# EUROPEAN PATENT SPECIFICATION

(11) **EP 1 813 667 B1**
(45) Date of publication and mention of the grant of the patent: **30.09.2009**
(21) Application number: 07250386.5
(22) Date of filing: 30.01.2007
(51) Int. Cl.: C11D 7/08, C11D 7/10, C11D 7/28, C11D 7/32, C11D 11/00

(54) **Cleaning formulations**
Reinigungsmittelformulierungen
Formules de nettoyages

(30) Priority: 30.01.2006 US 342414
(43) Date of publication of application: 01.08.2007
(73) Proprietor: Air Products and Chemicals, Inc., Allentown, PA 18195-1501 (US)
(72) Inventor: Rao, Madhukar Bhaskara, Fogelsville PA 18051 (US); Marsella, John Anthony, Allentown PA 18104 (US); Wieder, Thomas Michael, Emmaus PA 18049 (US); Listemann, Mark Leo, Kutztown PA 19530 (US)
(74) Representative: Muir, Benjamin M. J.

(56) References cited:
- WO-A-96/30488
- DE-A1- 10 331 033
- DE-B- 1 227 178
- US-A1- 2005 096 237

## Description

### BACKGROUND OF THE INVENTION

The present invention provides cleaning compositions that can be used for a variety of applications including, for example, removing unwanted resist films, post-etch, and post-ash residue on a semiconductor substrate. In particular, the present invention provides cleaning compositions that comprise a urea derivative as a cleaning agent.

The background of the present invention will be described in connection with its use in cleaning applications involving the manufacture of integrated circuits. It should be understood, however, that the use of the present invention has wider applicability as described hereinafter.

In the manufacture of integrated circuits, it is sometimes necessary to etch openings or other geometries in a thin film deposited or grown on the surface of silicon, gallium arsenide, glass, or other substrate located on an in-process integrated circuit wafer. Present methods for etching such a film require that the film be exposed to a chemical etching agent to remove portions of the film. The particular etching agent used to remove the portions of the film depends upon the nature of the film. In the case of an oxide film, for example, the etching agent may be hydrofluoric acid. In the case of a polysilicon film, it will typically be hydrofluoric acid or a mixture of nitric acid and acetic acid.

In order to assure that only desired portions of the film are removed, a photolithography process is used, through which a pattern in a computer drafted photo mask is transferred to the surface of the film. The mask serves to identify the areas of the film which are to be selectively removed. This pattern is formed with a photoresist material, which is a light sensitive material spun onto the in-process integrated circuit wafer in a thin film and exposed to high intensity radiation projected through the photo mask. The exposed or unexposed photoresist material, depending on its composition, is typically dissolved with developers, leaving a pattern which allows etching to take place in the selected areas, while preventing etching in other areas. Positive-type resists, for example, have been extensively used as masking materials to delineate patterns on a substrate that, when etching occurs, will become vias, trenches, contact holes, etc.

Increasingly, a dry etching process such as, for example, plasma etching, reactive ion etching, or ion milling is used to attack the photoresist-unprotected area of the substrate to form the vias, trenches, contact holes, etc.. As a result of the plasma etching process, photoresist, etching gas and etched material by-products are deposited as residues around or on the sidewall of the etched openings on the substrate.

Such dry etching processes also typically render the resist mask extremely difficult to remove. For example, in complex semiconductor devices such as advanced DRAMS and logic devices with multiple layers of back end lines of interconnect wiring, reactive ion etching (RIE) is used to produce vias through the interlayer dielectric to provide contact between one level of silicon, silicide or metal wiring to the next level of wiring. These vias typically expose, Al, AlCu, Cu, Ti, TiN, Ta, TaN, silicon or a silicide such as, for example, a silicide of tungsten, titanium or cobalt. The RIE process leaves a residue on the involved substrate comprising a complex mixture that may include, for example, re-sputtered oxide material, polymeric material derived from the etch gas, and organic material from the resist used to delineate the vias.

Additionally, following the termination of the etching step, the photoresist and etch residues must be removed from the protected area of the wafer so that the final finishing operation can take place. This can be accomplished in a plasma "ashing" step by the use of suitable plasma ashing gases. This typically occurs at high temperatures, for example, above 200°C. Ashing converts most of the organic residues to volatile species, but leaves behind on the substrate a predominantly inorganic residue. Such residue typically remains not only on the surface of the substrate, but also on inside walls of vias that may be present. As a result, ash-treated substrates are often treated with a cleaning composition typically referred to as a "liquid stripping composition" to remove the highly adherent residue from the substrate. Finding a suitable cleaning composition for removal of this residue without adversely affecting, e.g., corroding, dissolving or dulling, the metal circuitry has also proven problematic. Failure to completely remove or neutralize the residue can result in discontinuances in the circuitry wiring and undesirable increases in electrical resistance.

Prior art stripping compositions have included, for example: (a) organic sulfonic acid-based stripping solutions that contain an alkyl benzenesulfonic acid as the main stripping component; and (b) organic amine-based stripping solutions that contain an amine such as monoethanol amine as the main stripping component. Such prior art stripping compositions for removing the etching residue suffer, however, from significant drawbacks. For example, their use tends to erode copper wire exposed on the bottoms of via holes.

Cleaning compositions containing dimethyl acetamide (DMAC) are used widely for removing residue from semiconductor substrates, see for instance DE 103 31 033. DMAC is particularly suitable for such applications because it is highly polar, which makes it an excellent solvent for organic residues. DMAC is also desirable because it has a high flashpoint, it is water soluble, it has a low viscosity, and it is relatively inexpensive. Unfortunately, however, DMAC is classified as a toxic material in both the United States and in Europe. In this regard, DMAC has an NPFA health rating of 2 and its MSDS indicates that it is easily absorbed through the skin. Toxicity data also suggests that DMAC may be an embryotoxin and, as such, its use has been discouraged in Europe and has received extensive scrutiny in the United States and Asia. As a result, the electronic industry, for example, will not use cleaning compositions that include DMAC.

DE 103 31 033 alson suggests alkylurea derivatives as solvents.

Therefore, there is a need in the art for a cleaning composition that is non-toxic and environmentally friendly for back-end cleaning operations including stripping photoresist and plasma ash residue such as, for example, those generated by plasma processes.

### BRIEF SUMMARY OF THE INVENTION

The present invention satisfies this need by providing a composition useful for removing residue from a semiconductor substrate comprising, in effective cleaning amounts, water, at least one urea derivative as the cleaning component, and a fluoride source. The composition according to the present invention includes optionally other materials such as, for example, one or more of a water-miscible organic solvent, a buffering agent, and a corrosion-inhibitor.

In one embodiment, the present invention provides a composition which is useful for removing residue from a semiconductor substrate and which comprises, in effective cleaning amounts, water; at least one urea derivative, selected from 1,1-dimethylurea, 1,3-dimethylurea, 1,1,3-trimethylurea, 1,3-bis(2-hydroxyethyl)urea, 1-methyl, 3-(2-hydroxypropyl)urea and mixtures thereof; and a fluoride ion source; and optionally: a water-miscible organic solvent; a buffering agent; and a corrosion-inhibitor. In preferred embodiments of the cleaning composition, the urea derivative is selected from the group consisting of 1,1-dimethylurea and 1,3-dimethylurea and the fluoride ion source is ammonium fluoride.

In another embodiment, the present invention provides a method for removing unwanted residues from a substrate such as, for example, a semiconductor substrate. The method includes the steps of contacting the substrate with a composition according to the present invention, rinsing the cleaning composition from the substrate, and drying the substrate.

The composition of the present invention has excellent cleaning properties, is less toxic, and is more environmentally acceptable than compositions that are currently being used in the semiconductor industry.

### BRIEF DESCRIPTION OF SEVERAL VIEWS OF THE DRAWINGS

Results of the use of cleaning compositions within the scope of the present invention and of comparative compositions are illustrated in the accompanying drawings, which consist of the following Figures:
Figure 1 includes SEM photographs at different magnifications of a semiconductor substrate with unwanted residue prior to a cleaning operation;
Figure 2 includes SEM photographs at different magnifications of a semiconductor substrate after cleaning with a cleaning composition according to the present invention;
Figure 3 includes SEM photographs at different magnifications of a semiconductor substrate after cleaning with a cleaning composition according to the present invention;
Figure 4 includes SEM photographs at different magnifications of a semiconductor substrate after cleaning with the composition of Comparative Example A; and
Figure 5 includes SEM photographs at different magnifications of a semiconductor substrate after cleaning with the composition of Comparative Example C.

### DETAILED DESCRIPTION OF THE INVENTION

The present invention provides a composition whose components are present in amounts that effectively remove residue from a substrate such as, for example, a semiconductor substrate. In applications concerning semiconductor substrates, such residues include, for example, photoresist residues, ash residues, and etch residues such as, for example, residues caused by reactive ion etching. Moreover, a semiconductor substrate also includes metal, silicon, silicate and/or inter-level dielectric material such as deposited silicon oxides, which will also come into contact with the cleaning composition. Typical metals include copper, copper alloy, titanium, titanium nitride, tantalum, tantalum nitride, aluminum and/or aluminum alloy. The cleaning composition of the present invention is compatible with such materials as they exhibit a low metal and/or dielectric etch rate.

The cleaning composition of the present invention is aqueous-based and, thus, comprises water. In the present invention, water functions in various ways such as, for example, to dissolve one or more solid components of the composition, as a carrier of the components, as an aid in the removal of the residue, as a viscosity modifier of the composition, and as a diluent. Preferably, the water employed in the cleaning composition is de-ionized (DI) water.

It is believed that, for most applications, water will comprise, for example, from 10 to 90% by wt. of the composition. Some preferred embodiments of the present invention could comprise from 18 to 90% by wt. of water,more preferably from 35 to 60% by wt. of water. Other preferred embodiments of the present invention could comprise from 12 to 25% by wt. of water. Still other preferred embodiments of the present invention could include water in an amount to achieve the desired weight percent of the other ingredients.

The cleaning composition of the present invention comprises an urea derivative that functions as a cleaning agent that principally solubilizes or aids in solubilizing organic residue that is present on the substrate.

The urea derivatives are selected from 1,1-dimethylurea, 1,3-dimethylurea, 1,1,3,3-tetramethylurea, 1,3-bis(2-hydroxyethyl) urea, and 1-methyl-3-(2-hydroxypropyl) urea, and mixtures thereof. The most preferred urea derivative is 1,3-dimethylurea.

It is believed that, for most applications, the amount of the urea derivative will comprise from 2 to 75% by weight of the composition. Preferably the urea derivative comprises from 5 to 70% by weight and, most preferably, from 5% to 67% by weight of the composition.

The urea derivative for use in the composition of the present invention is relatively non-toxic compared to conventional organic solvent-based cleaning agents such as, for example, DMAC or N-methyl pyrrolidone and they have excellent cleaning properties. In preferred form, they are highly polar, have high solubility in water, and are biodegradable.

The cleaning composition of the present invention also comprises one or more sources of fluoride ion. Fluoride ion functions principally to assist in removing inorganic residues from the substrate. Typical compounds that provide a fluoride ion source according to the present invention are hydrofluoric acid and salts thereof, ammonium fluoride, quaternary ammonium fluorides such as, for example, tetramethylammonium fluoride and tetrabutylammonium fluoride, fluoroborates, fluoroboric acid, tetrabutylammonium tetrafluoroborate, and aluminum hexafluoride. Also, a fluoride salt of an aliphatic primary, secondary or tertiary amine can be used, for example, an amine of the formula:

R₅N(R₆)R₇

wherein R₅, R₆ and R₇ individually represent H or a (C₁-C₄) alkyl group. Typically, the total number of carbon atoms in the R₅, R₆ and R₇ groups is 12 carbon atoms or less.

In a preferred embodiment, the fluoride ion source is ammonium fluoride; however, when ammonium fluoride is used, it is preferable to remove ammonium ions from the system. Although this can be accomplished by allowing the prepared cleaning composition to stand at room temperature for a long period of time, they can also be removed by heating the solution.

In selecting the source of the fluoride ion, consideration should be given as to whether or not the source would tend to release ions which would tend to affect adversely the surface being cleaned. For example, in cleaning semiconductor elements, the presence of sodium or calcium ions in the cleaning composition can have an adverse effect on the surface of the element.

It is believed that the amount of the compound used as the source of the fluoride ion in the cleaning composition will, for the most applications, comprise, 0.1 to 5% by weight. Preferably, the compound comprises from 0.1 to 3% by weight and, most preferably, from 0.1 to 2.5% by weight. It should be understood that the amount of fluoride ion used will typically depend, however, on the particular substrate being cleaned. For example, in certain cleaning applications, the amount of the fluoride ion can be relatively high when cleaning substrates that comprise dielectric materials that have a high resistance to fluoride etching. Conversely, in other applications, the amount of fluoride ion should be relatively low, for example, when cleaning substrates that comprise dielectric materials that have a low resistance to fluoride etching.

The cleaning composition of the present invention optionally includes one or more water-miscible organic solvents. In various embodiments of the present invention, metal lines on the substrate typically dictate whether a water-miscible organic solvent is used. For example, when aluminum lines are present on a substrate, the combination of water and fluoride ion will typically tend to etch the aluminum. In such embodiments, the use of water-miscible organic solvent can significantly reduce, if not eliminate, etching of aluminum.

Examples of water-miscible organic solvents that can be used are ethylene glycol, propylene glycol, 1,4-butanediol, tripropylene glycol methyl ether, propylene glycol propyl ether, diethylene gycol n-butyl ether (e.g. commercially available under the trade designation Dowanol DB), hexyloxypropylamine, poly(oxyethylene)diamine, dimethylsulfoxide, tetrahydrofurfuryl alcohol, glycerol, alcohols, sulfoxides, or mixtures thereof. Preferred solvents are alcohols, diols, or mixtures thereof. Most preferred solvents are diols such as, for example, propylene glycol.

It is believed that, for most applications, the amount of water-miscible organic solvent will comprise from 5 to 75% by weight of the composition. Preferably, the solvent comprises from 5 to 70% or from 10 to 75% by weight and, most preferably, from 5% to 67% by weight of the composition.

In addition, the cleaning composition of the present invention optionally includes a buffering agent to control the pH of the composition, typically to within a range of from 3 to 6 and, more typically, from 3.5 to 5.5. There are various applications in which the use of buffering is advantageous, indeed even quite important. For example, in some applications, pH drift can cause significant and undesirable variances in cleaning and substrate etching; a semi-aqueous fluoride-containing stripper at pH of 4.75 may not etch copper significantly, but at pH of 7.5 or higher, the stripper may severely attack copper, causing unacceptable loss of a device critical dimension.

Buffering agents for use in the present invention typically comprise a weak acid and a soluble salt containing the conjugate base of the weak acid. For example, the buffering agent can comprise a weak organic monoacid and its conjugate base such as, for example, acetic acid and ammonium acetate. In other embodiments, the buffering agent may comprise an organic or inorganic base in combination with an organic diacid. Examples of suitable bases include: ammonium hydroxide, amines, and quaternary ammonium hydroxides. In semiconductor applications, it is preferred that the base not include metal ions, for example, sodium and potassium, because they tend to contaminate the substrate. Preferred bases are ammonium hydroxide and monoethanolamine (MEA).

The pH of the cleaning composition can vary anywhere from 1 to 7, or, more typically, 5.5 to 6.0, depending on the specific mono or diacid chosen and its effective buffering range. Diacids, for example, are defined by two pKa values and a buffer is generally formed about 0.75 pH units on either side of a given pKa. For example, the pK values for malonic acid are pK1=2.8 and pK2=5.7. One can then expect malonic acid to act as a buffer between the pHs of 2.05-3.55 and again between 4.95-6.45. Similarly, the pK values for adipic acid are pK1=4.5 and pK2=5.5. Since the two pHs almost overlap, the effective buffering range of adipic acid is between the pHs of 3.75 and 6.25.

It is believed that for most applications, the buffering agent, will comprise from 0.2 to 30% by weight of the composition; preferably, it comprises from 0.5 to 30% by weight; most preferably, from 0.5 to 28% by weight of the composition.

The cleaning composition of the present invention also optionally includes a corrosion-inhibitor. The use of a corrosion-inhibitor is preferred when the composition is used to clean a metallic substrate. Examples of corrosion-inhibitors include aromatic hydroxyl compounds, acetylenic alcohols, carboxyl group-containing organic compounds and anhydrides thereof, and triazole compounds.

Exemplary aromatic hydroxyl compounds include phenol, cresol, xylenol, pyrocatechol, resorcinol, hydroquinone, pyrogallol, 1.2.4-benzenetriol, salicyl alcohol, p-hydroxybenzyl alcohol, o-hydroxybenzyl alcohol, p-hydroxyphenethyl alcohol, p-aminophenol, m-aminophenol, diaminophenol, amino resorcinol, p-hydroxybenzoic acid, o-hydroxybenzoic acid 2,4-dihydroxybenzoic acid, 2,5-dihydroxybenzoic acid, 3,4-dihydroxybenzoic acid and 3,5-dihydroxybenzoic acid.

Exemplary acetylenic alcohols include 2-butyne-1,4-diol, 3,5-dimethyl-1-hexyn-3-ol, 2-methyl-3-butyn-2-ol, 3-methyl-1-pentyn-3-ol, 3,6-dimethyl-4-octyn-3,6-diol, 2,4-,7,9-tetramethyl-5-decyne-4,7-diol and 2,5-dimethyl-3-hexyne-2,5-diol.

Exemplary carboxyl group-containing organic compounds and anhydrides thereof include formic acid, acetic acid, propionic acid, butyric acid, isobutyric acid, oxalic acid, malonic acid, succinic acid, glutaric acid, maleic acid, fumaric acid, benzoic acid, phthalic acid, 1,2,3-benzenetricarboxylic acid, glycolic acid, lactic acid, maleic acid citric acid, acetic anhydride and salicylic acid.

Exemplary triazole compounds include benzotriazole, o-tolyltriazole, m-tolyltriazole, p-tolyltriazole, carboxybenzotriazole, 1-hydroxybenzotriazole, nitrobenzotriazole and dihydroxypropylbenzotriazole.

Preferred inhibitors are catechol, gallic acid, benzotriazole, pyrogallol, 4-methyl catechol fumaric acid and diethylhydroxylamine (DEHA); it is preferred that an inhibitor other than benzotriazole be used when cleaning a substrate comprising copper because benzotriazole has a tendency to bind to copper.

It is believed that for most applications, the corrosion-inhibitor will comprise from 0.01 to 5% by weight of the composition; preferably it comprises from 0.01 to 4% by weight, more preferably, from 0.01 3% by weight of the composition, and most preferably from 0.01 to 2.5% by weight.

Another optional ingredient that can be used in the cleaning composition is a metal chelating agent; it can function to increase the capacity of the composition to retain metals in solution and to enhance the dissolution of metallic residues. Typical examples of chelating agents useful for this purpose are the following organic acids and their isomers and salts: (ethylenedinitrilo)tetraacetic acid (EDTA), butylenediaminetetraacetic acid, (1,2-cyclohexylenedinitrilo-)tetraacetic acid (CyDTA), diethylenetriaminepentaacetic acid (DETPA), ethylenediaminetetrapropionic acid, (hydroxyethyl)ethylenediaminetriacetic acid (HEDTA), N,N,N',N'-ethylenediaminetetra(methylenephosphonic) acid (EDTMP), triethylenetetraminehexaacetic acid (TTHA), 1,3-diamino-2-hydroxypropane-N,N,N',N'-tetraacetic acid (DHPTA), methyliminodiacetic acid, propylenediaminetetraacetic acid, nitrolotriacetic acid (NTA), citric acid, tartaric acid, gluconic acid, saccharic acid, glyceric acid, oxalic acid, phthalic acid, maleic acid, mandelic acid, malonic acid, lactic acid, salicylic acid, catechol, gallic acid, propyl gallate, pyrogallol, 8-hydroxyquinoline, and cysteine. Preferred chelating agents are aminocarboxylic acids such as EDTA, CyDTA and aminophosphonic acids such as EDTMP.

It is believed that, for most applications, the chelating agent will be present in the composition in an amount of from 0 to 5% by weight, preferably in an amount of from 0.1 to 2% by weight of the composition.

Other commonly known components such as dyes, biocides etc. can be included in the cleaning composition in conventional amounts, for example, amounts up to a total of about 5 weight % of the composition.

The cleaning composition of the present invention is typically prepared by mixing the components together in a vessel at room temperature until all solids have dissolved in the aqueous-based medium.

The cleaning composition of the present invention can be used to remove from a substrate undesired residue. It is believed that the composition can be used to particularly good advantage in cleaning a semiconductor substrate on which residue is deposited or formed during the process for manufacturing semiconductor devices; examples of such residue include resist compositions in the form of films (both positive and negative) and etching deposits formed during dry etching, as well as chemically degraded resist films. The use of the composition is particularly effective when the residue to be removed is a resist film and/or an etching deposit on a semiconductor substrate having a metal film-exposed surface. Examples of substrates that can be cleaned by use of the composition of the present invention without attacking the substrates themselves include metal substrates, for example: aluminum titanium/tungsten; aluminum/silicon; aluminum/silicon/copper; silicon oxide; silicon nitride; and gallium/arsenide. Such substrates typically include residues comprising photoresists and/or post etch deposits.

Examples of resist compositions that can be effectively removed by use of the cleaning composition of the present invention include photoresists containing esters or ortho-naphthoquinones and novolak-type binders and chemically amplified resists containing blocked polyhydroxystyrene or copolymers of polyhydroxystyrene and photoacid generators. Examples of commercially available photoresist compositions include Clariant Corporation AZ 1518, AZ 4620, Shipley Company, Inc. photoresists, S1400, APEX-E™ positive DUV, UV5™ positive DUV, Megaposit™ SPR™ 220 Series; JSR Microelectronics photoresists KRF™ Series, ARF™ Series; and Tokyo Ohka Kogyo Co., Ltd. Photoresists TSCR Series and TDUR-P/N Series.

In addition to being effective when used to remove resist films and/or etching residues on a semiconductor wafer having an exposed surface of a metal film, the cleaning composition is especially effective when the metal film is made of copper or a copper alloy containing copper as the main component and also when a low-dielectric film is used as an interlayer insulating film. An example of a copper alloy containing copper as the main component is one containing 90% by weight or more copper, and other elements, for example, Sn, Ag, Mg, Ni, Co, Ti, Si, and Al. Since these metals have low resistances and improve the high-speed operation of elements, but are easily dissolved or corroded by chemicals, the "non-corrosive" properties of the composition of the present invention are significant.

The cleaning composition can be used to remove post-etch and ash, other organic and inorganic residues as well as polymeric residues from semiconductor substrates at relatively low temperatures with little corrosive effect. The cleaning composition should be applied to the surface for a period of time to sufficient to obtain the desired cleaning effect. The time will vary depending on numerous factors, including, for example, the nature of the residue the temperature of the cleaning composition and the particular cleaning composition used. In general, the cleaning composition can be used, for example, by contacting the substrate at a temperature of from 25° C to 85° C for a period of time ranging from 1 minute to 1 hour followed by rinsing the cleaning composition from the substrate and drying the substrate.

The contacting step can be carried out by any suitable means such as, for example, immersion, spray, or via a single wafer process; any method that utilizes a liquid for removal of photoresist, ash or etch deposits and/or contaminants can be used.

The rinsing step is carried out by any suitable means, for example, rinsing the substrate with de-ionized water by immersion or spray techniques. In preferred embodiments, the rinsing step is carried out employing a mixture of de-ionized water and a water-miscible organic solvent such as, for example, isopropyl alcohol.

The drying step is carried out by any suitable means, for example, isopropyl alcohol (IPA) vapor drying or by centripetal force.

It will be appreciated by those skilled in the art that the cleaning composition of the present invention may be modified to achieve optimum cleaning without damaging the substrate so that high throughput cleaning can be maintained in the manufacturing process. For example, one skilled in the art would appreciate that, for example, modifications to the amounts of some or all of the components may be made depending upon the composition of the substrate being cleaned, the nature of the residue to be removed, and the particular process parameters used.

Although the present invention has been principally described in connection with cleaning semiconductor substrates, the cleaning compositions of the invention can be employed to clean any substrate that includes organic and inorganic residues.

### EXAMPLES

The following examples are provided for the purpose of further illustrating the present invention but are by no means intended to limit the same.

### General Procedure for Preparing the Cleaning Compositions

All compositions which are the subject of the present Examples were prepared by mixing 500g of material in a 600mL beaker with a 1" (2½cm) Teflon™-coated stir bar. For compositions without a water-miscible organic solvent, the first material added to the beaker was deionized (DI) water. Dimethyl urea, which is highly soluble in water, was added next. When using relatively large amounts of solid dimethyl urea (DMU), it is recommended that the DMU be added to the water as it is stirred until the aqueous solution is clear. The remaining components can then be added in any order, but the preferred order, as used in the present examples, is (1) acetic acid, (2) ammonium fluoride, (40%), and (3) ammonium acetate, if used.

For compositions that include a water-miscible organic solvent, the composition is mixed as stated above, but the solvent such as, for example, propylene glycol, is preferably added to the water before the dimethyl urea is introduced. The resulting solution will take a bit longer to turn clear since the urea is not as soluble in propylene glycol as it is in water.

### Compositions of the Substrate

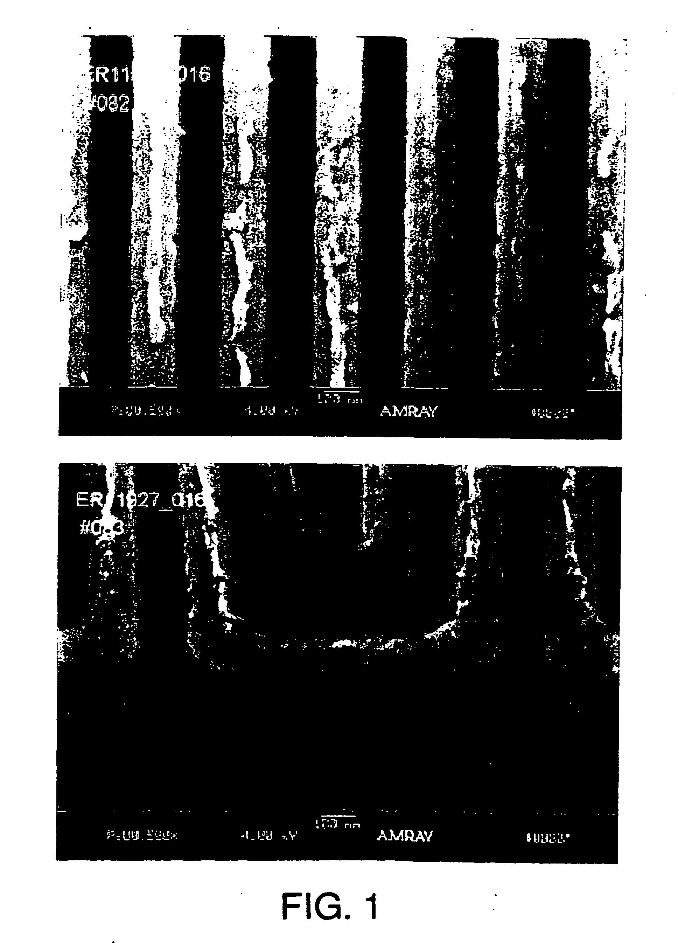

Each substrate used in the present Examples comprised an organosilicate glass (OSG) dielectric material with a titanium nitride capping layer that was deposited on a silicon nitride substrate. The OSG was etched by reactive ion etching (RIE) to leave behind OSG lines capped with titanium nitride. Following RIE, the substrates were treated in a plasma to ash the photoresist. Figure 1 shows the residues on the substrate prior to cleaning.

### Processing Conditions

Cleaning tests were run using 305 mL of the cleaning compositions in a 400mL beaker with a ½" (1¹/₄cm) round Teflon™ stir bar set at 600 rpm. The cleaning compositions were heated to the desired temperature indicated below on a hot plate if necessary. Wafer segments approximately ½" x ½" (1¹/₄cm x 1¹/₄cm ) in size were immersed in the compositions under the following set of conditions.
10 minutes @ 25°C
20 minutes @ 25°C
10 minutes @ 35°C
20 minutes @ 35°C

The segments were then rinsed for 3 minutes in a Dl water overflow bath and subsequently dried using filtered nitrogen. They were then analyzed for cleanliness using SEM microscopy.

### Etch Rate Measurement Procedure

Coupons of the blanket Al or blanket Cu wafers were measured for metal layer thickness by measuring the resistivity of the layer by employing a ResMap™ model 273 resistivity instrument from Creative Design Engineering, Inc. The coupons were then immersed in the composition at the desired temperature for up to one hour. Periodically the coupons were removed from the composition, rinsed with de-ionized water and dried and the thickness of the metal layer was again measured. A graph of the change in thickness as a function of immersion time was made and the etch rate in Angstroms/min (0.1 nm/min) was determined from the slope of the curve.

Table 1 identifies the components of the composition tested and referenced below.

**Table 1**

| **Component** | **Example 1** | **Example 2** | **Comp. Example A** | **Comp. Example B** | **Comp. Example C** | **Comp. Example D** |
|---|---|---|---|---|---|---|
| Dimethyl Urea^{a} | 36.95 | 36.95 | | | | |
| Cyclic Urea^{b} | | | 73.9 | | | |
| Urea | | | | 35 | 35 | 36.95 |
| Water | 61.95 | 25.0 | 25.0 | 60 | 65 | 25.0 |
| Propylene Glycol | | 36.95 | | | | 36.95 |
| Acetic Acid | 0.5 | 0.5 | 0.5 | | | 0.5 |
| Ammonium Fluoride Aq. Sol. (40%) | 0.4 | 0.4 | 0.4 | | | 0.4 |
| Ammonium Acetate | 0.2 | 0.2 | 0.2 | | | 0.2 |
| Gallic Acid | | | | 5 | | |
| Cleanability | Excellent | Excellent | Poor | Not Soluble | Poor | Not Soluble |

| | | | | | | |
|---|---|---|---|---|---|---|
| a = 1,3-dimethyl urea b = 1-2-Hydroxyethyl)-2-imidazolidinone (75% aqueous solution) | | | | | | |

Tables 2 and 3 summarize etch rates of Examples 1 and 2, respectively.

**Table 2**

| **Formulation of Example 1** | | |
|---|---|---|
| **Substrate** | **Temp. (°C)** | **Etch Rate (Å/min)** |
| Al | 25 | 409 |
| Cu | 25 | 1 |
| Coral | 25 | < 1 |
| Coral | 35 | < 1 |
| TEOS* | 25 | 1 |
| TEOS* | 40 | 2 |
| TEOS** | 25 | 2 |
| TEOS** | 40 | 7 |

| | | |
|---|---|---|
| * = Undoped, Undensified ** = P-doped, Undensified | | |

**Table 3**

| **Formulation of Example 2** | | |
|---|---|---|
| **Substrate** | **Temp. (ºC)** | **Etch Rate (Å/min)** |
| Al | 25 | 12 |
| Al | 35 | 21 |
| Cu | 25 | 2 |
| Cu | 35 | 3 |

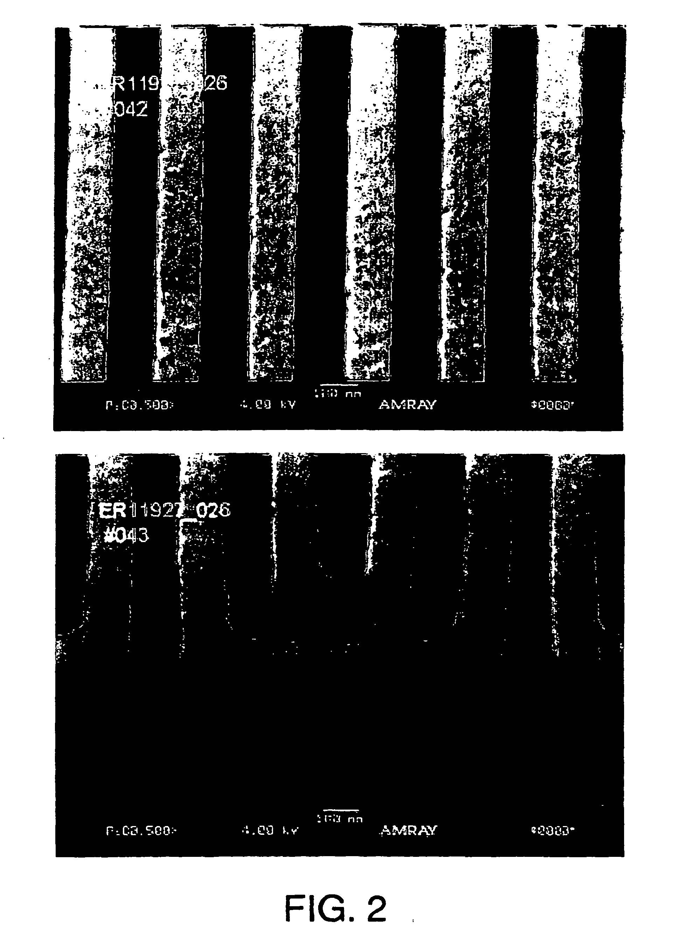

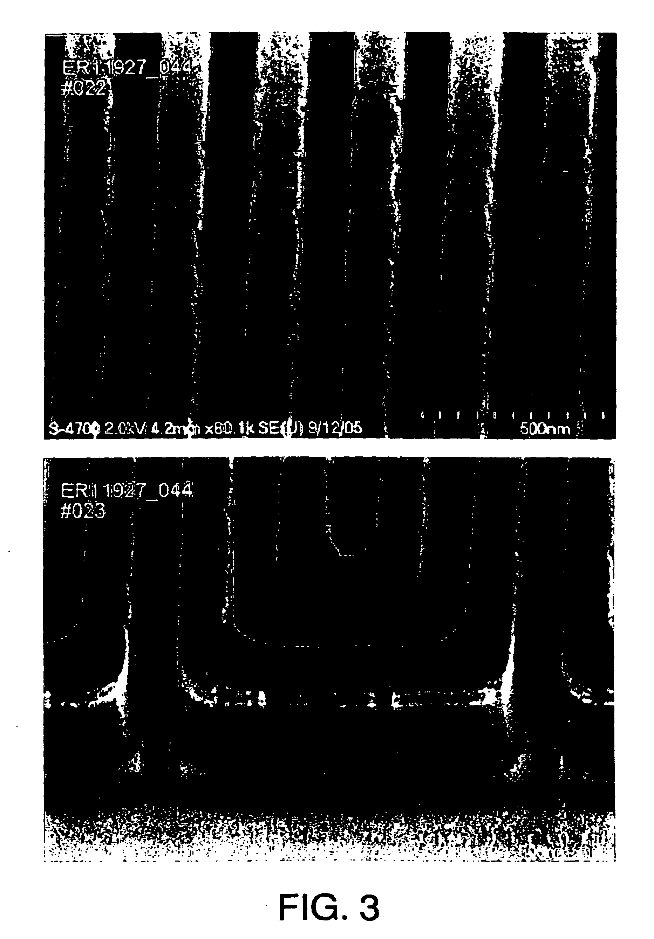

The compositions of Examples 1 and 2 are cleaning compositions according to the present invention wherein dimethyl urea is the cleaning agent. Figures 2 and 3 illustrate that the compositions of Examples 1 and 2, respectively, are cleaning compositions that are effective at removing etch and ash residue from the surface of a semiconductor wafer. Table 2 demonstrates that the compositions of Examples 1 and 2 effectively clean without etching the metals on the substrate.

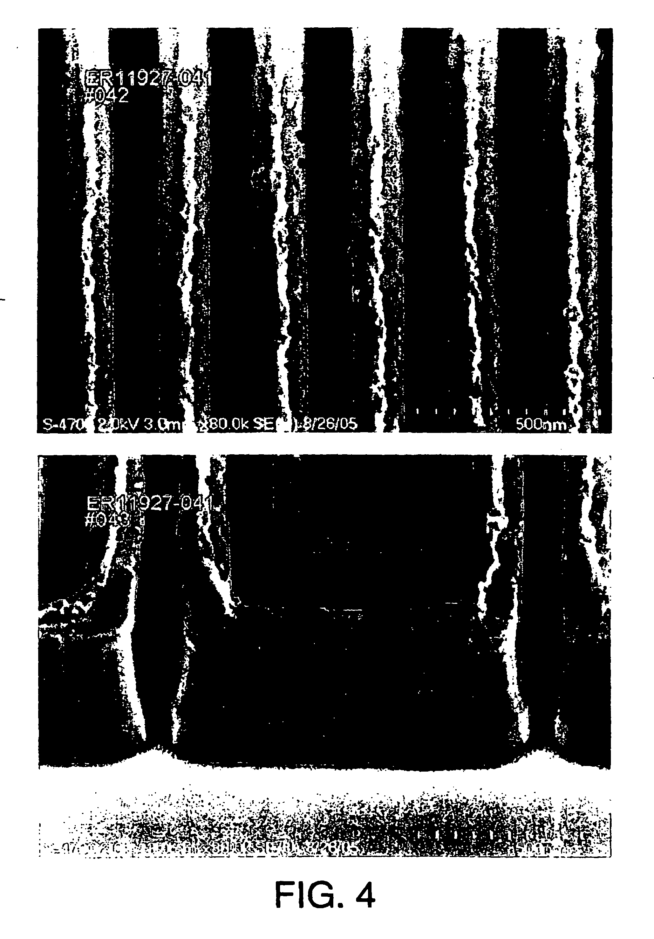

The composition of Comparative Example A is similar to that of Example 1 except for the urea derivative component. In this regard, the composition of Comparative Example A employs a cyclic urea such as, for example, the kind disclosed in U.S. Patent No. 6,423,480, as the cleaning agent. Figure 4 illustrates that such cyclic ureas are ineffective at removing etch and ash residue from the surface of a semiconductor wafer.

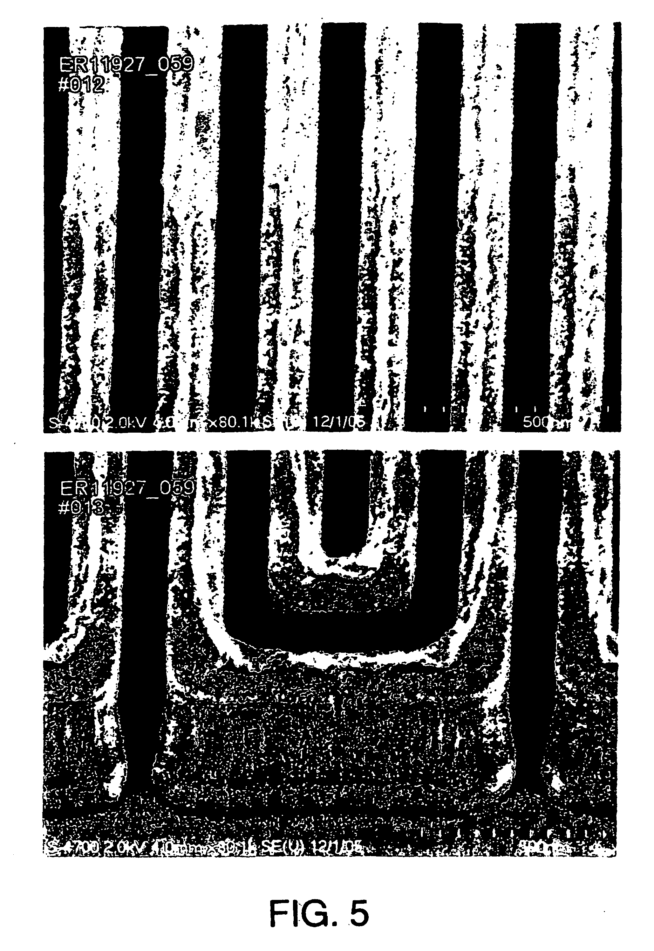

Comparative Examples B, C, and D compare the cleaning performance of compositions disclosed in the U.S. patent application Publication No. 2001/0014534 ("the 534 publication"). Figure 5 shows the result of cleaning a semiconductor wafer with the composition of Comparative Example C, which employed urea at 35% of the composition. A Comparison of Figure 5 with Figures 2 and 3 demonstrates that the cleaning compositions of the present invention are more effective at removing etch and ash residue from the surface of a semiconductor wafer. This result is consistent with the teachings of the 534 publication, which relies on N-methyl-ethanolamine as the cleaning agent.

The compositions of Comparative Examples B and D were prepared to analyze the cleaning performance of urea. The composition of Comparative Example B consists of urea, gallic acid, and water and was prepared to evaluate composition 2 at Table 1 of the 534 publication without the cleaning agent, monoethanolamine, to see whether the urea would clean. The composition of Comparative Example D is similar to Example 2 except that the urea derivative component of Example 2 was replaced with urea. Neither of Comparative Examples B or D could be evaluated because all of the components were not soluble in the solution.

The foregoing examples and description of the preferred embodiments should be taken as illustrating, rather than as limiting the present invention as defined by the claims. As will be readily appreciated, numerous variations and combinations of the features set forth above can be utilized without departing from the present invention as set forth in the claims. Such variations are not regarded as a departure from the scope of the invention, and all such variations are intended to be included within the scope of the following claims.

## Claims

1. A composition useful for removing residue from a semiconductor substrate comprising in effective cleaning amounts:
a) water;
b) at least one urea derivative selected from 1,1-dimethylurea, 1,3-dimethylurea, 1,1,3-trimethylurea, 1,3-bis(2-hydroxyethyl) urea, 1-methyl, 3-(2-hydroxypropyl) urea, and mixtures thereof;
c) a fluoride ion source;
d) optionally a water-miscible organic solvent;
e) optionally a buffering agent; and
f) optionally a corrosion inhibitor.

2. The composition of claim 1, wherein the urea derivative is selected from 1,1-dimethylurea and 1,3-dimethylurea.

3. The composition of any preceding claim, wherein the fluoride ion source is selected from hydrofluoric acid, tetramethylammonium fluoride, tetrabutylammonium fluoride, fluoroborates, fluoroboric acid, aluminum hexafluoride, ammonium fluoride, methylamine hydrofluoride, ethylamine hydrofluoride, propylamine hydrofluoride and a fluoride salt of an aliphatic primary, secondary or tertiary amine having the formula R₅N(R₆)R₇, wherein R₅, R₆ and R₇ each represent individually H or a (C₁-C₄) alkyl group.

4. The composition of claim 3, wherein the fluoride ion source is ammonium fluoride.

5. The composition of any preceding claim, including a water-miscible organic solvent which is selected from propylene glycol, tripropylene glycol methyl ether, 1,4-butanediol, propylene glycol propyl ether, diethylene gycol n-butyl ether, hexyloxypropylamine, poly(oxyethylene)diamine, tetrahydrofurfuryl alcohol, and mixtures thereof.

6. The composition of claim 5, wherein the water-miscible organic solvent which is propylene glycol.

7. The composition of any preceding claim, including a buffering agent comprising a diacid.

8. The composition of any one of claims 1 to 6, including a buffering agent which comprises acetic acid and ammonium acetate.

9. The composition of any preceding claim, including a corrosion inhibitor selected from aromatic hydroxyl compounds, acetylenic alcohols, carboxyl group containing organic compounds and anhydrides thereof, triazole compounds, and mixtures thereof.

10. The composition of claim 9 wherein the corrosion inhibitor is selected from catechol, gallic acid, pyrogallol, 4-methyl catechol fumaric acid, diethylhydroxylamine, and mixtures thereof.

11. A cleaning composition according to claim 1, the composition comprising:
a) from 10.0% by wt. to 90.0% by wt. of water;
b) from 2.0% by wt. to 75.0% by wt. of the urea derivative;
c) from 0.1% by wt. to 5.0% by wt. of a fluoride ion source;
d) optionally from 5.0% by wt. to 75.0% by wt. of at least one water-miscible organic solvent;
e) optionally from 0.2% by wt. to 30.0% by wt. of a buffering agent; and
f) optionally from 0.01% by wt. to 5.0% by wt. of a corrosion inhibitor.

12. The composition of claim 11, consisting essentially of:
a) from 18.0% by wt. to 90.0% by wt. of water;
b) from 5.0% by wt. to 67.0% by wt. of the urea derivative;
c) from 0.1% by wt. to 2.5% by wt. of a fluoride ion source;
d) from 0.5% by wt. to 28.0% by wt. of a buffering agent; and
e) from 0.01 % by wt. to 2.5% by wt. of a corrosion inhibitor.

13. The composition of claim 11, consisting essentially of:
a) from 12.0% by wt. to 25.0% by wt. of water;
b) from 5.0% by wt. to 67.0% by wt. of the urea derivative;
c) from 0.1% by wt. to 2.5% by wt. of a fluoride ion source;
d) from 5.0% by wt. to 67.0% by wt. of at least one water-miscible organic solvent;
e) from 0.5% by wt. to 28.0% by wt. of a buffering agent; and
f) from 0.01% by wt. to 2.5% by wt. of a corrosion inhibitor.

14. The composition of any one of claims 11 to 13, wherein the urea derivative, the fluoride ion source, the water-miscible organic solvent, the buffering agent, and/or the corrosion inhibitor are as defined in any one of claims 2 to 10.

15. The composition of any preceding claim claim, further including a chelating agent.

16. A method for removing residue from a substrate, the method comprising the steps of:
contacting the substrate with a cleaning composition comprising:
a) from 10.0% by wt. to 90.0% by wt. of water;
b) from 2.0% by wt. to 75% by wt. of a urea derivative selected from 1,1-dimethylurea, 1,3-dimethylurea, 1,1,3-trimethylurea, 1,3-bis(2-hydroxyethyl) urea, 1-methyl, 3-(2-hydroxypropyl) urea, and mixtures thereof;
c) from 0.1% by wt. to 5.0% by wt. of a fluoride ion source;
d) optionally from 5.0% by wt. to 75.0% by wt. of at least one water-miscible organic solvent;
e) optionally from 0.2% by wt. to 30.0% by wt. of a buffering agent; and
f) optionally from 0.01% by wt. to 5.0% by wt. of a corrosion inhibitor; rinsing the cleaning composition from the substrate; and
drying the substrate.

17. The method of claim 16, wherein the substrate is a semiconductor substrate.

18. The method of claim 16 or 17, wherein the cleaning composition is as further defined in claim 12 or 13.

19. The method of claim 16, 17 or 18, wherein the urea derivative, the fluoride ion source, the water-miscible organic solvent, the buffering agent, and/or the corrosion inhibitor are as defined in any one of claims 2 to 10.

20. The method of any one of claims 16 to 19, wherein the cleaning composition further includes a chelating agent.

## Patentansprüche

1. Zusammensetzung, nützlich zum Entfernen von Rückstand von einem Halbleitersubstrat, umfassend in wirksamen reinigenden Mengen:
a) Wasser;
b) mindestens ein Harnstoff derivat, ausgewählt aus 1,1-Dimethylharnstoff, 1,3-Dimethylharnstoff, 1,1,3-Trimethylharnstoff, 1,3-Bis(2-hydroxyethyl)harnstoff, 1-Methyl,3-(2-hydroxypropyl)harnstoff und Gemischen davon;
c) eine Fluoridionenquelle;
d) gegebenenfalls ein wassermischbares organisches Lösungsmittel;
e) gegebenenfalls ein Puffermittel; und
f) gegebenenfalls einen Korrosionsinhibitor.

2. Zusammensetzung nach Anspruch 1, wobei die Verbindung der Formel (I) aus 1,1-Dimethylharnstoff und 1,3-Dimethylharnstoff ausgewählt ist.

3. Zusammensetzung nach einem vorhergehenden Anspruch, wobei die Fluoridionenquelle aus Fluorwasserstoffsäure, Tetramethylammoniumfluorid, Tetrabutylammoniumfluorid, Fluorboraten, Fluorborsäure, Aluminiumhexafluorid, Ammoniumflourid, Methylamin-Hydrofluorid, Ethylamin-Hydrofluorid, Propylamin-Hydrofluorid und einem Fluoridsalz eines aliphatischen primären, sekundären oder tertiären Amins mit der Formel R₅N(R₆)R₇, wobei R₅, R₆ und R₇ jeweils unabhängig H oder einen (C₁-C₄)-Alkylrest darstellen, ausgewählt ist.

4. Zusammensetzung nach Anspruch 3, wobei die Fluoridionenquelle Ammoniumfluorid ist.

5. Zusammensetzung nach einem vorhergehenden Anspruch, einschließend ein wassermischbares organisches Lösungsmittel, welches aus Propylenglykol, Tripropylenglykolmethylether, 1,4-Butandiol, Propylenglykolpropylether, Diethylenglykol-n-butylether, Hexyloxypropylamin, Poly(oxyethylen)diamin, Tetrahydrofurfurylalkohol und Gemischen davon ausgewählt ist.

6. Zusammensetzung nach Anspruch 5, wobei das wassermischbare organische Lösungsmittel Propylenglykol ist.

7. Zusammensetzung nach einem vorhergehenden Anspruch, einschließend ein Puffermittel, umfassend eine Disäure.

8. Zusammensetzung nach einem der Ansprüche 1 bis 6, einschließend ein Puffermittel, welches Essigsäure und Ammoniumacetat umfasst.

9. Zusammensetzung nach einem vorhergehenden Anspruch, einschließend einen Korrosionsinhibitor, ausgewählt aus aromatischen Hydroxylverbindungen, acetylenischen Alkoholen, Carboxylgruppe-enthaltenden organischen Verbindungen und Anhydriden davon, Triazolverbindungen und Gemischen davon.

10. Zusammensetzung nach Anspruch 9, wobei der Korrosionsinhibitor aus Catechol, Gallussäure, Pyrogallol, 4-Methylcatecholfumarsäure, Diethylhydroxylamin und Gemischen davon ausgewählt ist.

11. Reinigungszusammensetzung gemäß Anspruch 1, wobei die Zusammensetzung umfasst:
a) 10,0 Gew.-% bis 90,0 Gew.-% Wasser;
b) 2,0 Gew.-% bis 75,0 Gew.-% des Harnstoffderivats;
c) 0,1 Gew.-% bis 5,0 Gew.-% einer Fluoridionenquelle;
d) gegebenenfalls 5,0 Gew.-% bis 75,0 Gew.-% von mindestens einem wassermischbaren organischen Lösungsmittel;
e) gegebenenfalls 0,2 Gew.-% bis 30,0 Gew.-% von einem Puffermittel; und
f) gegebenenfalls 0,01 Gew.-% bis 5,0 Gew.-% von einem Korrosionsinhibitor.

12. Zusammensetzung nach Anspruch 11, bestehend im Wesentlichen aus:
a) 18,0 Gew.-% bis 90,0 Gew.-% Wasser;
b) 5,0 Gew.-% bis 67,0 Gew.-% des Harnstoffderivats;
c) 0,1 Gew.-% bis 2,5 Gew.-% einer Fluoridionenquelle;
d) 0,5 Gew.-% bis 28,0 Gew.-% von einem Puffermittel; und
e) 0,01 Gew.-% bis 2,5 Gew.-% von einem Korrosionsinhibitor.

13. Zusammensetzung nach Anspruch 11, bestehend im Wesentlichen aus:
a) 12,0 Gew.-% bis 25,0 Gew.-% Wasser;
b) 5,0 Gew.-% bis 67,0 Gew.-% des Harnstoffderivats;
c) 0,1 Gew.-% bis 2,5 Gew.-% einer Fluoridionenquelle;
d) 5,0 Gew.-% bis 67,0 Gew.-% von mindestens einem wassermischbaren organischen Lösungsmittel;
e) 0,5 Gew.-% bis 28,0 Gew.-% von einem Puffermittel; und
f) 0,01 Gew.-% bis 2,5 Gew.-% von einem Korrosionsinhibitor.

14. Zusammensetzung nach einem der Ansprüche 11 bis 13, wobei das Harnstoffderivat, die Fluoridionenquelle, das wassermischbare organische Lösungsmittel, das Puffermittel und/oder der Korrosionsinhibitor wie in einem der Ansprüche 2 bis 10 definiert sind.

15. Zusammensetzung nach einem vorhergehenden Anspruch, ferner einschließend ein Chelat-bildendes Mittel.

16. Verfahren zum Entfernen von Rückstand von einem Substrat, wobei das Verfahren die folgenden Schritte umfasst:
das Inkontaktbringen des Substrats mit einer Reinigungszusammensetzung, umfassend:
a) 10,0 Gew.-% bis 90,0 Gew.-% Wasser;
b) 2,0 Gew.-% bis 75 Gew.-% eines Harnstoffderivats, ausgewählt aus1,1-D methylharnstoff, 1,3-Dimethylharnstoff, 1,1,3-Trimethylharnstoff, 1,3-Bis(2-hydroxyethyl)harnstoff, 1-Methyl,3-(2-hydroxypropyl)harnstoff und Gemischen davon;
c) 0,1 Gew.-% bis 5,0 Gew.-% einer Fluoridionenquelle;
d) gegebenenfalls 5,0 Gew.-% bis 75,0 Gew.-% von mindestens einem wassermischbaren organischen Lösungsmittel;
e) gegebenenfalls 0,2 Gew.-% bis 30,0 Gew.-% von einem Puffermittel; und
f) gegebenenfalls 0,01 Gew.-% bis 5,0 Gew.-% von einem Korrosionsinhibitor;
das Spülen der Reinigungszusammensetzung von dem Substrat; und
das Trocknen des Substrats.

17. Verfahren nach Anspruch 16, wobei das Substrat ein Halbleitersubstrat ist.

18. Verfahren nach Anspruch 16 oder 17, wobei die Reinigungszusammensetzung wie ferner in Anspruch 12 oder 13 definiert ist.

19. Verfahren nach Anspruch 16, 17 oder 18, wobei das Harnstoffderivat die Fluoridionenquelle, das wassermischbare organische Lösungsmittel, das Puffermittel und/oder der Korrosionsinhibitor wie in einem der Ansprüche 2 bis 10 definiert sind.

20. Verfahren nach einem der Ansprüche 16 bis 19, wobei die Reinigungszusammensetzung ferner ein Chelat-bildendes Mittel einschließt.

## Revendications

1. Composition utile pour retirer un résidu d'un substrat semi-conducteur comprenant en quantités de nettoyage effectives:
a) de l'eau;
b) au moins un dérivé d'urée sélectionné à partir de 1, 1-dyméthylurée, 1, 3-dyméthylurée, 1, 1, 3-triméthylurée, 1, 3-bis (2-hydroxyéthyle) urée, 1-méthyle, 3-(2-hydroxypropyle) urée, et des mélanges de ceux-ci;
c) une source d'ions fluorure;
d) facultativement, un solvant organique miscible dans l'eau;
e) facultativement, un agent tampon; et
f) facultativement, un inhibiteur de corrosion.

2. Composition de la revendication 1, dans laquelle le dérivé d'urée est sélectionné à partir de 1, 1-dyméthylurée et 1, 3-dyméthylurée.

3. Composition de l'une des revendications précédentes, dans laquelle la source d'ions fluorure est sélectionnée à partir d'un acide fluorhydrique, de fluorure de tétraméthylammonium, de flurorure de tétrabutylammonium, de fluoroborates, d'un acide fluoroborique, de l'hexafluorure d'aluminium, de fluorure d'ammonium, de l'hydrofluorure de méthylamine, de l'hydrofluorure d'éthylamine, de l'hydrofluorure de propylamine et d'un sel de fluorure d'une amine aliphatique primaire, secondaire ou tertiaire ayant la formule R₅N(R₆)R₇, où R₅, R₆ et R₇ représentent chacun individuellement H ou un groupe alkyle en (C₁-C₄).

4. Composition de la revendication 3, dans laquelle la source d'ions fluorure est un fluorure d'ammonium.

5. Composition de l'une des revendications précédentes, incluant un solvant organique miscible dans l'eau qui est sélectionné à partir du propylène glycol, de l'éther méthylique de tripropylène glycol, 1, 4-butanédiol, de l'éther propylique de propylène glycol, de l'éther de n-butyle du diéthylène glycol, de l'hexyloxypropylamine, poly(oxyéthylène) diamine, alcool de tétrahydrofurfuryle, et des mélanges de ceux-ci.

6. Composition de la revendication 5, dans laquelle le solvant organique miscible dans l'eau est le propylène glycol.

7. Composition de l'une des revendications précédentes, incluant un agent tampon comprenant un diacide.

8. composition de l'une quelconque des revendications 1 à 6, incluant un agent tampon qui comprend un acide acétique et l'acétate d'ammonium.

9. Composition de l'une des revendications précédentes, incluant un inhibiteur de corrosion sélectionné à partir de composés hydroxylés aromatiques, d'alcools acétyléniques, d'un groupe carboxyle contenant des composés organiques et des anhydrides de ceux-ci, des composés de triazole, et des mélanges de ceux-ci.

10. Composition de la revendication 9 dans laquelle l'inhibiteur de corrosion est sélectionné à partir de la catéchine, l'acide gallique, du pyrogallol, l'acide fumarique 4-méthyle catéchine, la diéthylhydroxylamine, et des mélanges de ceux-ci.

11. Composition de nettoyage selon la revendication 1, la composition comprenant:
a) de 10,0% en poids à 90,0% en poids d'eau;
b) de 2,0% en poids à 75,0% en poids du dérivé d'urée;
c) de 0,1% en poids à 5,0% en poids d'une source d'ions fluorure;
d) facultativement, de 5,0% en poids à 75,0% en poids d'au moins un solvant organique miscible dans l'eau;
e) facultativement, de 0,2% en poids à 30,0% en poids d'un agent tampon; et
f) facultativement, de 0,01% en poids à 5,0% en poids d'un inhibiteur de corrosion.

12. Composition de la revendication 11, se composant essentiellement:
a) de 18,0% en poids à 90,0% en poids d'eau;
b) de 5,0% en poids à 67,0% en poids du dérivé d'urée;
c) de 0,1% en poids à 2,5% en poids d'une source d'ions fluorure;
d) de 0,5% en poids à 28,0% en poids d'un agent tampon; et
e) de 0,01% en poids à 2,5% en poids d'un inhibiteur de corrosion.

13. Composition de la revendication 11, se composant essentiellement:
a) de 12,0% en poids à 25,0% en poids d'eau;
b) de 5,0% en poids à 67,0% en poids du dérivé d'urée;
c) de 0,1 % en poids à 2,5%o en poids d'une source d'ions fluorure;
d) de 5,0% en poids à 67,0% en poids d'au moins un solvant organique miscible dans l'eau;
e) de 0,5% poids à 28,0% en poids d'un agent tampon; et
f) de 0,01% en poids à 2,5% en poids d'un inhibiteur de corrosion.

14. Composition de l'une quelconque des revendications 11 à 13, dans laquelle le dérivé d'urée, la source d'ions fluorure, le solvant organique miscible dans l'eau, l'agent tampon, et/ou l'inhibiteur de corrosion sont comme définis dans l'une quelconque des revendications 2 à 10.

15. Composition de l'une des revendications précédentes, incluant en plus un agent chélatant.

16. Procédé pour retirer un résidu d'un substrat, le procédé comprenant les étapes consistant à:
mettre le substrat en contact avec une composition de nettoyage comprenant:
a) de 10,0% en poids à 90,0% en poids d'eau;
b) de 2,0% en poids à 75% en poids d'un dérivé d'urée sélectionné à partir de 1, 1-dyméthylurée, 1, 3-dyméthylurée, 1, 1, 3-triméthylurée, 1, 3-bis (2-hydroxyéthyle) urée, 1-méthyle, 3-(2-hydroxypropyle) urée, et des mélanges de ceux-ci;
c) de 0,1% en poids à 5,0% en poids d'une source d'ions fluorure;
d) facultativement, de 5,0% en poids à 75,0% en poids d'au moins un solvant organique miscible dans l'eau;
e) facultativement, de 0,2% en poids à 30,0% en poids d'un agent tampon; et
f) facultativement, de 0,01 % en poids à 5,0% en poids d'un inhibiteur de corrosion;
rincer la composition de nettoyage du substrat; et
sécher le substrat.

17. Procédé de la revendication 16, dans lequel le substrat est un substrat semi-conducteur.

18. Procédé de la revendication 16 ou 17, dans lequel la composition de nettoyage est comme définie en outre dans la revendication 12 ou 13.

19. Procédé de la revendication 16, 17 ou 18, dans lequel le dérivé d'urée, la source d'ions fluorure, le solvant organique miscible dans l'eau, l'agent tampon, et/ou l'inhibiteur de corrosion sont comme définis dans l'une quelconque des revendications 2 à 10.

20. Procédé de l'une quelconque des revendications 16 à 19, dans lequel la composition de nettoyage inclut en plus un agent chélatant.
